# FASCICULE DE BREVET EUROPEEN

(11) **EP 0 706 311 B1**
(45) Date de publication et mention de la délivrance du brevet: **19.12.2001**
(21) Numéro de dépôt: 95114402.1
(22) Date de dépôt: 13.09.1995
(51) Int. Cl.: H05K 5/00

(54) **Entretoises et boîtier de commande électronique comportant de telles entretoises**
Abstandshalter und Gehäuse der Steuerelektronik, mit diesen Abstandshaltern
Spacers and casing for electronic control with the same spacers

(30) Priorité: 26.09.1994 FR 9411561
(43) Date de publication de la demande: 10.04.1996
(73) Titulaire: SIEMENS AUTOMOTIVE S.A., 31036 Toulouse Cédex (FR)
(72) Inventeur: Bergeret, Henri, F-31770 Colomiers (FR)
(74) Mandataire: Zedlitz, Peter, Dipl.-Inf.

(56) Documents cités:
- DE-U- 8 604 098
- FR-A- 2 669 179
- FR-A- 2 671 935
- US-A- 5 179 501
- US-A- 5 327 324

## Description

La présente invention concerne des entretoises et un boîtier électronique comportant de telles entretoises.

Les véhicules automobiles sont de plus en plus munis de dispositifs électroniques commandant le fonctionnement du moteur. Ces dispositifs sont généralement placés sous le capot du véhicule, ou dans des endroits non protégés, c'est pourquoi il est impératif de les disposer dans des boîtiers de protection. L'objet de tels boîtiers est bien sûr de rassembler dans un même lieu les dispositifs électroniques de commande, mais aussi d'assurer leur protection contre l'humidité (eau, carburant, autres liquides de fonctionnement du moteur), la chaleur, les perturbations électromagnétiques...etc.

Pour faciliter la réalisation de tels boîtiers il est en outre préférable qu'ils soient réalisés, si possible, à partir d'éléments plats mis en forme au dernier stade de leur fabrication. Il est également important que ces boîtiers soient facilement démontables, notamment pour leur réparation.

Pour réaliser de tels boîtiers, il est déjà connu d'utiliser des entretoises maintenant en place par vissage les différents éléments qui les composent. Mais ces entretoises une fois montées sont difficilement démontables. Or la facilité de démontage est un critère essentiel pour la réparation et / ou l'entretien de tels dispositifs électroniques.

L'objet de la présente invention est de pallier l'ensemble de ces inconvénients et de proposer un boîtier électronique facile à monter et à démonter et comportant le moins de pièces possibles.

A cet effet la présente invention concerne une entretoise pour un boîtier comportant un dispositif électronique de commande de véhicule automobile, le dit boîtier étant du genre comportant:
- au moins un circuit imprimé flexible, muni d'une pluralité de composants électroniques et solidaire d'une pluralité de substrats métalliques,
- un élément de fermeture, adapté pour loger à son intérieur le dit circuit imprimé,
- un élément frontal et,
- au moins une entretoise de fixation,
la dite entretoise étant caractérisée en ce qu'elle est constituée de moyens élastiques de hauteur inférieure à la distance séparant les parois dudit élément de fermeture à l'état replié et adaptés pour se déployer entre les substrats métalliques mis en place à l'intérieur de l'élément de fermeture du boîtier et pour appliquer ces substrats contre des parois de l'élément de fermeture, les dites entretoises étant soumises à des forces de compression lors de la fermeture d'un élément frontal.

Grâce à cette disposition le montage et le démontage des entretoises, et du boîtier sont aisés. En effet les entretoises qui maintiennent en place l'ensemble des éléments sont simplement insérées de manière élastique (et amovible) entre les substrats, et de ce fait le boîtier selon l'invention est facilement démontable.

Selon un premier mode de réalisation de l'invention, les entretoises présentent un contour fermé de forme sensiblement parallélépipédique.

Selon une variante de réalisation, les entretoises présentent un contour ouvert et sont adaptées pour coopérer avec des moyens de fixation réalisés dans l'élément de fermeture et / ou dans l'élément frontal.

D'autres objets, caractéristiques et avantages de la présente invention ressortiront d'ailleurs de la description qui va suivre en référence aux dessins annexés, dans lesquels:
- la figure 1 est une vue en perspective éclatée d'un boîtier électronique muni d'entretoises selon un mode de réalisation de l'invention,
- la figure 2 est une vue en coupe montrant notamment l'entretoise élastique selon un autre mode de réalisation de l'invention.

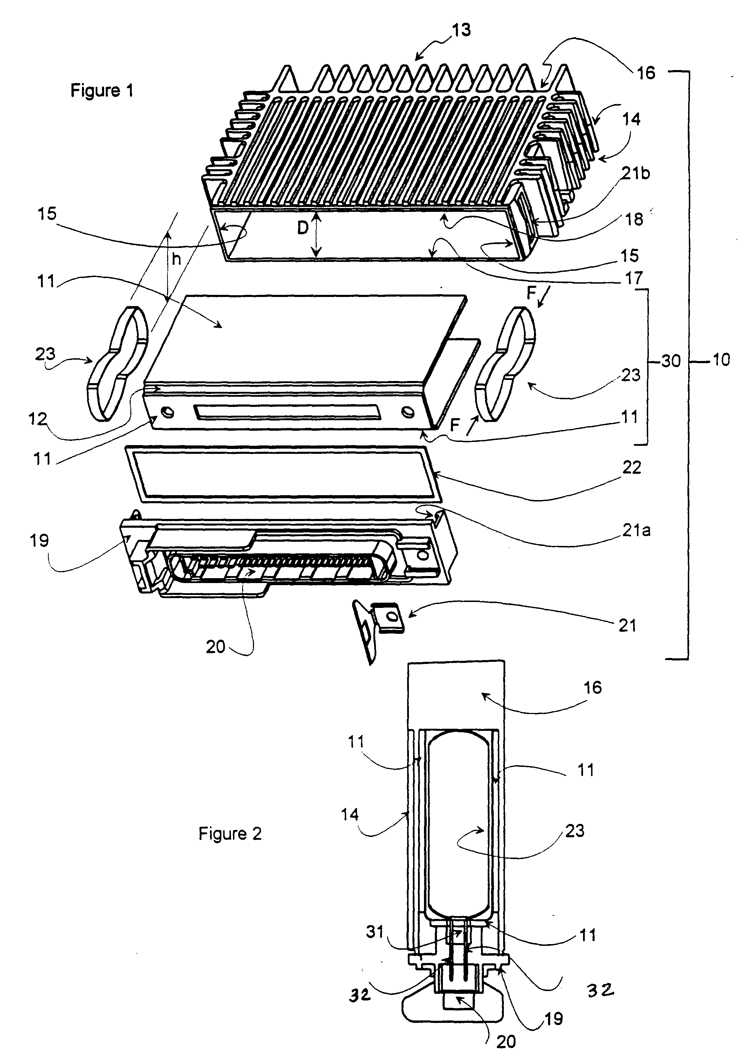

Selon la forme de réalisation représentée aux figures 1 et 2, un boîtier électronique 10 selon l'invention comporte trois substrats métalliques 11, solidaires d'un même circuit imprimé flexible 12. Comme on le voit notamment à la figure 1, ce film flexible relie de manière souple les différents substrats métalliques 11. Des composants électroniques (non représentés, pour ne pas surcharger le dessin) sont implantés sur le circuit flexible.

Lors de l'implantation des différents composants électroniques, les trois substrats métalliques et le circuit flexible associé sont disposés à plat. Lorsque tous les composants électroniques ont été mis en place, l'ensemble électronique 30, (constitué par les substrats, le circuit imprimé flexible et les composants électroniques) est replié sous la forme d'un U (figure 1) de telle sorte que les composants soient placés à l'intérieur du U (face cachée du dessin). Cet ensemble 30 est destiné a être placé à l'intérieur d'un élément de fermeture 13.

L'élément de fermeture 13 est réalisé en un matériau bon conducteur de chaleur et est muni d'une pluralité de moyens de refroidissement (dans le cas représenté des ailettes 14). Comme représenté à la figure 1 cet élément de fermeture 13 comporte des parois latérales 15, une paroi arrière 16, un fond 17 et un couvercle 18.

Un élément frontal 19, adapté pour recevoir un connecteur 20, présente des moyens de fixation 21 (de type connus) pour une partie complémentaire (non représentée) de ce connecteur. Des moyens de fixation 21a sont également ménagés sur cet élément frontal et sont adaptés pour coopérer avec des moyens de fixation 21 b ménagés sur l'élément de fermeture 13.

Un joint d'étanchéité 22 est interposé entre l'ensemble électronique 30 et l'élément frontal 19.

Les entretoises 23 selon un mode de réalisation de l'invention présentent un contour fermé et sont placées en contact avec le substrat 11, entre les deux branches du U de l'ensemble électronique 30. Ces entretoises présentent un état replié (représenté à la figure 1) dans lequel leur forme est sensiblement celle d'un huit (dans le cas représenté) et un état déployé représenté à la figure 2. A l'état replié la hauteur h de l'entretoise est inférieure à la distance D séparant le couvercle 18 et le fond 17 de l'élément de fermeture 13.

Le montage d'un tel boîtier est réalisé de la manière ci après décrite.

L'ensemble électronique 30 replié sous forme de U (figure 1) et comportant à son intérieur deux entretoises 23 à l'état replié est introduit dans l'élément de fermeture 13. Comme la hauteur h des entretoises est inférieure à la distance D séparant le fond 17 et le couvercle 18 de l'élément de fermeture 13, cette introduction se fait sans aucun problème.

L'élément frontal 19 et son joint 22 sont ensuite mis en place de manière à refermer l'élément de fermeture 13. Cette fermeture est réalisée par la coopération des moyens de fixations 21a et 21b. Lors de cette fermeture les entretoises 23 sont soumises à des forces de compression (flèches F). Ceci provoque un gonflement des entretoises qui présentent alors un état déployé (figure 2). Dans cet état les entretoises plaquent les substrats métalliques 11 contre les parois 17 et 18 (le fond et le couvercle) de l'élément de fermeture 13. On réalise ainsi un boîtier électronique 10 fermé et dans lequel les substrats métalliques 11 sont plaqués contre les parois de l'élément de fermeture 13.

De manière avantageuse, les entretoises 23 et les zones qu'elles contactent sur les substrats métalliques 11 sont réalisées dans des matériaux bons conducteurs de chaleur. De ce fait, la chaleur émise par les composants électroniques est transmise aux substrats métalliques, puis aux parois de l'élément de fermeture, qui évacuent cette chaleur vers l'extérieur du boîtier. La bonne dissipation de la chaleur émise par les composants électroniques est donc conditionnée par la qualité du contact entre le substrat métallique 11 et les parois de l'élément de fermeture. La bonne qualité de ce contact est garantie par la compression des entretoises entre l'élément frontal 19 et la paroi arrière 16 de l'élément de fermeture 13.

Selon une variante de réalisation la zone de contact entre l'entretoise 23 et le substrat 11 est recouverte de cuivre. Toutes les masses du boîtier sont ainsi reliées entre elles, ce qui assure une protection efficace du boîtier contre les perturbations électromagnétiques.

On notera que l'utilisation d'entretoises élastiques amovibles en tant que moyen de maintien des différents éléments du boîtier les uns par rapport aux autres est avantageuse. Elle permet, en effet un maintien mécanique des différents éléments sans réelle fixation de ceux ci. En outre un certain jeu mécanique est possible au moment du montage entre l'ensemble électronique 30 (déformable grâce au circuit flexible) et l'élément de fermeture 13.

Le démontage d'un tel boîtier est aisé ce qui facilite les interventions nécessaires dans le cadre de réparations. En outre en raison de la flexibilité de l'ensemble électronique celui-ci peut être replacé en position plane (pour sa réparation) si nécessaire.

Comme le montre notamment la figure 2, l'entretoise selon l'invention peut présenter un contour ouvert. Dans ce cas chacune de ces extrémités 32 s'ancre dans la face avant 19. Dans le cas représenté les extrémités 32 s'emboîtent en force dans un élément de retenu 31 solidaire de la face avant 19.

En variante (non représentée) le moyen de retenu 31 est ménagé sur l'élément de fermeture 13.

En variante (non représentée) les entretoises 23 peuvent être fixées sur les substrats métalliques 11 par des points de soudure ou être maintenues en place par rapport aux substrats par la coopération de bossages réalisés sur les entretoises et / ou sur les substrats.

On notera que lors du démontage d'un tel boîtier (lors d'une réparation par exemple) on n'exerce pas de traction sur les substrats métalliques, mais directement sur les entretoises. Ainsi la sortie de l'ensemble électronique 30 de l'élément de fermeture ne provoque pas la détérioration du circuit imprimé flexible.

Egalement le nombre de substrats métalliques peut être inférieur ou supérieur à celui représenté.

## Revendications

1. Entretoise pour boîtier électronique de commande de véhicule automobile, le dit boîtier (10) étant du genre comportant:
- au moins un circuit imprimé flexible (12) muni d'une pluralité de composants électroniques et solidaire d'une pluralité de substrats métalliques (11),
- un élément de fermeture (13), adapté pour loger à son intérieur le dit circuit imprimé,
- un élément frontal (19) et,
- au moins une entretoise (23). la dite entretoise étant **caractérisée en ce qu'**elle est constituée de moyens élastiques de hauteur (h) inférieure à la distance (D) séparant les parois (17, 18) dudit élément (13) à l'état replié et adaptés pour se déployer entre les dits substrats métalliques (11) mis en place à l'intérieur de l'élément de fermeture (13) du boîtier (10) et pour appliquer ces substrats contre les dites parois (17, 18) de l'élément de fermeture, les dites entretoises (23) étant soumises à des forces de compression (F) lors de la fermeture d'un élément frontal (19).

2. Entretoise selon la revendication 1, **caractérisé en ce que** le circuit imprimé flexible (12) est adapté pour relier de manière souple au moins deux substrats métalliques (11).

3. Entretoise selon la revendication 1 ou 2, **caractérisée en ce qu'**elle réalise une connexion électrique entre les substrats métalliques (11) et l'élément de fermeture (13), de telle sorte que toutes les masses du boîtier soient reliées entres elles pour assurer une protection du boîtier contre les ondes électromagnétiques.

4. Entretoise selon l'une des revendications 1 à 3, **caractérisée en ce qu'**elle est amovible.

5. Entretoise selon l'une des revendications précédentes, **caractérisée en ce qu'**elle est constituée par un élément élastique à contour fermé.

6. Entretoise selon l'une des revendications 1 à 4, **caractérisée en ce qu'**elle est constituée par un élément élastique ouvert et présente deux extrémités (30).

7. Boîtier électronique notamment adapté pour la commande du moteur d'un véhicule automobile, **caractérisé en ce qu'**il comporte l'entretoise selon la revendication 1.

## Patentansprüche

1. Abstandshalter für ein Steuerelektronik-Gehäuse eines Kraftfahrzeuges, wobei das Gehäuse (10) aufweist:
- mindestens eine flexible gedruckte Schaltung (12), die mit mehreren elektronischen Bauelementen versehen und mit mehreren metallischen Substraten (11) fest verbunden ist,
- ein Verschlussglied (13), das zum Aufnehmen der gedruckten Schaltung in seinem Inneren dient,
- ein Frontglied (19) und
- mindestens einen Abstandshalter (23), der **dadurch gekennzeichnet ist, dass** er von elastischen Mitteln gebildet wird, deren Höhe (h) kleiner als der Abstand (D) zwischen den Wänden (17, 18) des Verschlussgliedes (13) im gefalteten Zustand ist und die in der Lage sind, sich zwischen den metallischen Substraten (11) im Inneren des Verschlussgliedes (13) des Gehäuses (14) aufzuweiten und diese Substrate gegen die Wände (17, 18) des Verschlussgliedes anzudrücken, wobei die Abstandshalter (23) Kompressionskräften (F) beim Schließen eines Frontgliedes (19) ausgesetzt sind.

2. Abstandshalter nach Anspruch 1, **dadurch gekennzeichnet, dass** die flexible gedruckte Schaltung (12) in der Lage ist, mindestens zwei metallische Substrate (11) biegsam miteinander zu verbinden.

3. Abstandshalter nach Anspruch 1 oder 2, **dadurch gekennzeichnet, dass** er eine elektrische Verbindung zwischen den metallischen Substraten (11) und dem Verschlussglied (13) so herstellt, dass alle Massen des Gehäuses untereinander verbunden sind, um einen Schutz des Gehäuses gegen elektromagnetische Wellen sicherzustellen.

4. Abstandshalter nach einem der Ansprüche 1 bis 3, **dadurch gekennzeichnet, dass** er entfernbar ist.

5. Abstandshalter nach einem der vorhergehenden Ansprüche, **dadurch gekennzeichnet, dass** er von einem elastischen Element mit geschlossener Kontur gebildet wird.

6. Abstandshalter nach einem der Ansprüche 1 bis 4, **dadurch gekennzeichnet, dass** er von einem elastischen Element gebildet wird, das offen ist und zwei Enden (30) hat.

7. Elektronikgehäuse, insbesondere für die Steuerung einer Brennkraftmaschine eines Kraftfahrzeuges, **dadurch gekennzeichnet, dass** es den Abstandshalter nach dem Anspruch 1 aufweist.

## Claims

1. Spacer for a motor vehicle electronic control unit, the said unit (10) being of the kind comprising:
- at least one flexible printed circuit (12) equipped with a number of electronic components and secured to a number of metallic substrates (11),
- a closure element (13) capable of housing the said printed circuit within it,
- a front element (19), and
- at least one spacer (23), the said spacer being **characterized in that** it consists of elastic means of height (h) shorter than the distance (D) separating the walls (17, 18) of the said element (13) in the bent state and designed to deploy between the said metal substrates (11) fitted inside the closure element (13) of the unit (10) and to press these substrates against the said walls (17, 18) of the closure element, the said spacers (23) being subjected to compressive forces (F) when a front element (19) is closed.

2. Spacer according to Claim 1, **characterized in that** the flexible printed circuit (12) is designed to flexibly connect at least two metal substrates (11).

3. Spacer according to Claim 1 or 2, **characterized in that** it makes an electrical connection between the metal substrates (11) and the closure element (13) so that all the earths of the unit are connected together to afford the unit with protection against electromagnetic waves.

4. Spacer according to one of Claims 1 to 3, **characterized in that** it is removable.

5. Spacer according to one of the preceding claims, **characterized in that** it consists of an elastic element with a closed outline.

6. Spacer according to one of Claims 1 to 4, **characterized in that** it consists of an open elastic element and has two ends (30).

7. Electronic unit particularly designed for controlling the engine of a motor vehicle, **characterized in that** it comprises the spacer according to Claim 1.
